# EUROPEAN PATENT APPLICATION

(11) **EP 2 884 289 A1**
(43) Date of publication of application: **17.06.2015**
(21) Application number: 13196492.6
(22) Date of filing: 10.12.2013
(51) Int. Cl.: G01R 15/20

(54) **Chip scale current sensor package and method of producing a current sensor package**

(71) Applicant: ams AG, 8141 Unterpremstätten (AT)
(72) Inventor: Etschmaier, Harald, 8010 Graz (AT)
(74) Representative: Epping - Hermann - Fischer

(57) **Abstract**

The chip scale current sensor package comprises an IC chip (1) including a sensor (5) for measuring a magnetic field, and an electrically conductive layer (2) applied to a main surface (10) of the IC chip. The sensor is arranged for a measurement of a magnetic field generated by an electric current (6) flowing in the electrically conductive layer, and the electrically conductive layer is insulated from contact pads (4) electrically connecting the IC.

## Description

Electric current sensors are used for a variety of applications. An electric current can be measured indirectly by a measurement of the magnetic field generated by the current. Sensor devices that are suitable for this purpose are magnetoresistive sensors or Hall sensors, for example. Magnetoresistive sensors use the property of a material to change its electrical resistance when an external magnetic field is applied.

Hall sensors employ the Hall effect, which produces a voltage across a conductor carrying an electric current when a magnetic field is present in a direction perpendicular to that of the current flow. A Hall sensor usually comprises a plate of an electrically conducting material provided on opposite edges with electrodes serving to apply an operation voltage generating an electric current through the plate. In the presence of a magnetic field with a component that is perpendicular to the plate, a Hall voltage is generated in a direction that is orthogonal both to the current and to this component of the magnetic field and can be detected by means of further electrodes provided at opposite edges of the plate in the direction transverse to the current. A Hall sensor can be realized as a semiconductor device with integrated circuit and manufactured in CMOS technology, for example.

As the magnetic field decreases with increasing distance between the magnetic field sensor and the current generating the magnetic field, the semiconductor die comprising the sensor has to be located close to the conductor carrying the current to be measured, so that the magnetic field will be strong enough in the vicinity of the sensor.

US 5,041,780 discloses an integrable current sensor, wherein a current conductor is provided on top of a semiconductor substrate comprising the magnetic field sensing elements.

US 6,356,068 B1 discloses a lead frame based current sensor package with integrated current path and flip chip assembly.

US 6,424,018 B1 discloses an example of a semiconductor device with a Hall element and a conductor arranged on top of the semiconductor substrate.

US 6,995,315 B2 and US 7,166,807 B2 disclose current sensors with magnetic field sensors based on lead frame technology.

US 7,598,601 B2 discloses a current sensor with lead frames forming a current conductor portion and a substrate comprising a magnetic field sensing element arranged above a current conductor portion provided by the lead frame.

US 8,400,139 B2 discloses a substrate (PCB) based package with integrated current path.

EP 1 111 693 B1 discloses a lead frame based package with slotted leadframe design.

Current sensors based on lead frames, semiconductor substrates or ceramic carriers are expensive, and their sensitivity is rather low and deteriorates over the lifetime.

It is an object of the present invention to disclose a current sensor package that is easy to produce and enables improved performance of the sensor. It is a further object to disclose a method of producing such a current sensor package.

These objects are achieved with the chip scale current sensor package according to claim 1 and with the method of producing a current sensor package according to claim 9. Embodiments and variants derive from the dependent claims.

The chip scale current sensor package comprises an IC chip with a main surface, where IC pads are arranged for external electrical connection, a sensor provided in the IC chip for measuring a magnetic field, an electrical conductor arranged above the main surface, and contacts for applying an electric current to the electrical conductor. The electrical conductor is an electrically conductive layer applied to the main surface, the sensor is arranged for a measurement of a magnetic field generated by an electric current flowing in the electrically conductive layer, and the electrically conductive layer is insulated from the IC pads.

An embodiment of the chip scale current sensor package further comprises an insulation layer forming the main surface. The insulation layer has openings above the IC pads.

In a further embodiment the insulation layer is polyimide.

In a further embodiment the electrically conductive layer is a metal, which may especially comprise copper.

A further embodiment comprises a cover layer on the electrically conductive layer, and the cover layer has openings above the IC pads and above areas of the electrically conductive layer. The cover layer may be polyimide, for example.

In a further embodiment, solder balls are arranged in the openings of the cover layer.

The method of producing a current sensor package comprises providing an IC chip with a sensor for measuring a magnetic field, arranging IC pads for external electrical connection at a main surface of the IC chip, and arranging an electrical conductor above the main surface. The electrical conductor is applied to the main surface as an electrically conductive layer and provided with contacts for applying an electric current. The sensor is arranged for a measurement of a magnetic field generated by an electric current flowing in the electrically conductive layer, which is insulated from the IC pads.

In a variant of the method the electrically conductive layer is arranged between polyimide layers.

In a further variant of the method, the electrically conductive layer is a metal layer that is applied by electrochemical deposition.

In a further variant of the method, contact pads are arranged on the IC pads, and the contact pads are applied together with the electrically conductive layer and from the same material as the electrically conductive layer.

In a further variant of the method, a plurality of solder balls are formed on the electrically conductive layer.

The following is a detailed description of examples of the current sensor package and the method of producing the current sensor package in conjunction with the appended figures.
- Figure 1: is a perspective view of an embodiment of the current sensor package.
- Figure 2: shows an intermediate product of an example of the method of producing the current sensor package.
- Figure 3: shows a further intermediate product of the method, corresponding to Figure 1.
- Figure 4: shows a further intermediate product after an application of a cover layer.
- Figure 5: shows a further intermediate product after an application of solder balls.

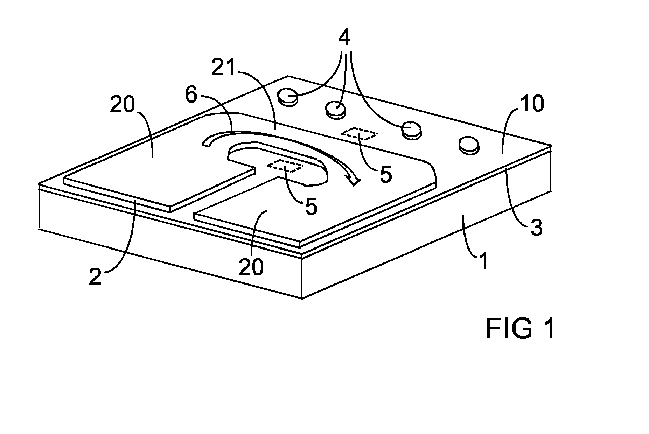

Figure 1 is a perspective view of an embodiment of the current sensor package. An IC Chip 1 is provided with an electrically conductive layer 2, which is directly applied on a main surface 10 of the IC chip 1 and galvanically isolated from all the electrical conductors belonging to the IC chip 1. The main surface 10 may be provided by an upper layer or cover of the IC chip 1, like an oxide layer of a wiring or a conventional passivation layer. Instead, a dedicated insulation layer 3, which may especially be polyimide, for instance, can be applied to form the main surface 10. The application of the insulation layer 3 may be preferred to enhance the insulation of the electrically conductive layer 2 from all the electrical conductors of the IC chip 1.

The electrically conductive layer 2 can comprise a metal like copper, for instance. The electrically conductive layer 2 can be structured according to individual requirements of an intended application of the sensor. In the example shown in Figure 1, the electrically conductive layer 2 comprises connection pads 20 for external electrical connection, in particular for the application of an electric current, and a current track 21 provided for the electrical current to be measured, which is indicated in Figure 1 by an arrow 6. By way of example, Hall sensor elements 5, which are integrated in the IC chip 1 in the vicinity of the current track 21, are indicated with broken lines as hidden contours. Contact pads 4 can be arranged on IC pads provided for electrical connection of the integrated circuit. The contact pads 4 can be formed together with the electrically conductive layer 2 and from the same material as the electrically conductive layer 2, so that the contact pads 4 are arranged on the level of the electrically conductive layer 2.

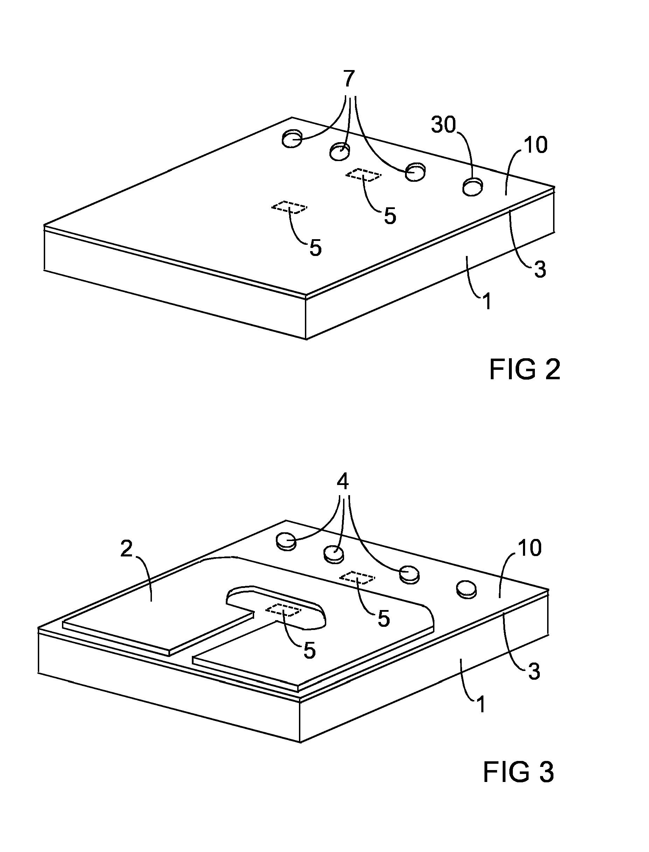

Figure 2 shows an intermediate product of an example of the method of producing the current sensor package. An insulation layer 3, which can be polyimide, for instance, is applied on the IC chip 1 and forms the main surface 10. Openings 30 of the insulation layer 3 are formed above IC pads 7, which are provided for external electrical connection of the integrated circuit. The integrated circuit can thus be electrically connected on the same side of the device as the electrically conductive layer 2. Instead or additionally, IC pads 7 may be arranged on the rear side of the IC chip 1, opposite the main surface 10 shown in Figure 2. The insulation layer 3 can be applied in a conventional way known per se in semiconductor technology.

Figure 3 is a perspective view according to Figure 2 of an intermediate product after the application of the electrically conductive layer 2, which is structured as shown in the corresponding Figure 1. The contact pads 4 on the IC pads 7 can be formed together with the electrically conductive layer 2 and from the same material. The electrically conductive layer 2 can be applied by electrochemical deposition, which is known per se. The electrically conductive layer 2 is preferably deposited on a seed layer, which may be formed before by physical vapour deposition, for instance. The electrically conductive layer 2 may comprise copper, for instance.

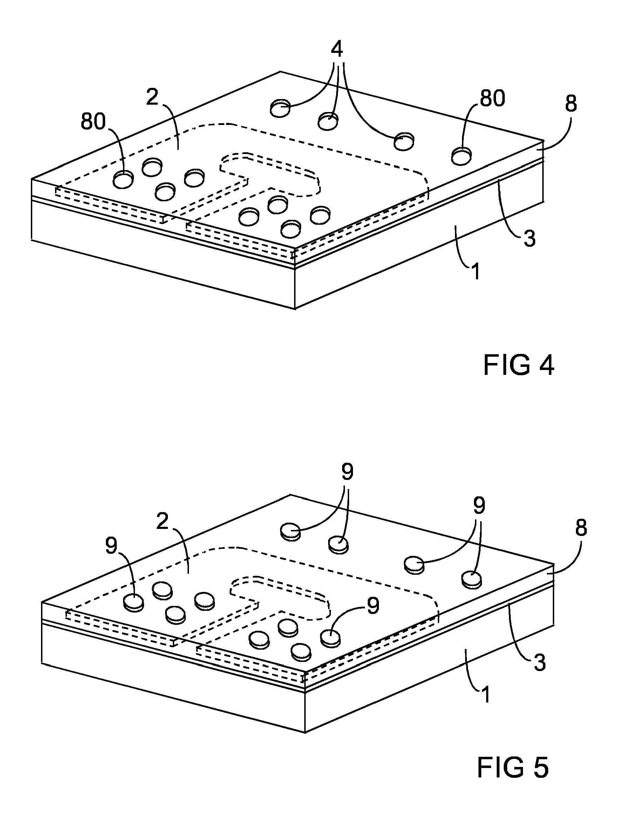

Figure 4 is a perspective view according to Figure 3 after the application of a cover layer 8, which may be polyimide, for instance. The cover layer 8 serves to insulate the electrically conductive layer 2 from above and is provided with openings 80 above the contact pads 4 and above areas of the connection pads 20 of the electrically conductive layer 2.

Figure 5 shows the product of this variant of the method after the application of solder balls 9 in the openings 80 of the cover layer 8. The solder balls 9 provide contacts for external electrical connection. The connection pads 20 of the electrically conductive layer 2 may preferably be provided with a plurality of solder balls 9 to reduce the resistance of the connection, as shown in Figure 5 as an example. Instead of solder balls, other contacts known per se from semiconductor technology can be applied.

The described chip scale current sensor package provides a new wafer level chip scale package (WLCSP), integrating a current track on the chip surface, galvanically isolated from the circuitry. This chip scale current sensor package has numerous advantages. The current track can easily be realized by a copper layer and can be deposited directly on the surface of the IC chip by process steps that are well known per se in semiconductor technology. The current track may be sandwiched between two polyimide layers for enhanced electrical isolation. It can be contacted on the outer surface, facing away from the IC chip, by conventional solder balls.

The production of the sensor device is therefore facilitated and cheaper in comparison with conventional current sensors. Furthermore, a wafer level package has the smallest possible footprint, which is a major advantage in view of a desired miniaturization of the sensor device. Testing and trimming of the device can be done on wafer level. Close tolerances in the geometry of the device can be observed more easily than in a backend assembly environment. Further to the lateral dimensions, also the distance between the conductor track and the sensor element can precisely be controlled. This in turn results in an improved accuracy of the sensor and also in a higher sensitivity.

### List of reference numerals

- 1: IC Chip
- 2: electrically conductive layer
- 3: insulation layer
- 4: contact pad
- 5: Hall sensor element
- 6: arrow
- 7: IC pad
- 8: cover layer
- 9: solder ball
- 10: main surface
- 20: connection pad
- 21: current track
- 30: opening
- 80: opening

## Claims

1. A chip scale current sensor package, comprising:
- an IC chip (1) comprising a main surface (10), where IC pads (7) are arranged for external electrical connection,
- a sensor (5) provided in the IC chip (1) for measuring a magnetic field,
- an electrical conductor (2) arranged above the main surface (10), and
- contacts (9) for applying an electric current to the electrical conductor (2),
**characterized in that**
- the electrical conductor (2) is an electrically conductive layer applied to the main surface (10),
- the sensor (5) is arranged for a measurement of a magnetic field generated by an electric current flowing in the electrically conductive layer (2), and
- the electrically conductive layer (2) is insulated from the IC pads (7).

2. The chip scale current sensor package of claim 1, further comprising:
an insulation layer (3) forming the main surface (10), the insulation layer (3) comprising openings (30) above the IC pads (7).

3. The chip scale current sensor package of claim 2, wherein the insulation layer (3) is polyimide.

4. The chip scale current sensor package of one of claims 1 to 3, wherein the electrically conductive layer (2) is a metal.

5. The chip scale current sensor package of one of claims 1 to 3, wherein the electrically conductive layer (2) comprises copper.

6. The chip scale current sensor package of one of claims 1 to 5, further comprising:
a cover layer (8) on the electrically conductive layer (2), the cover layer (8) having openings (80) above the IC pads (7) and above areas of the electrically conductive layer (2).

7. The chip scale current sensor package of claim 6, wherein the cover layer (8) is polyimide.

8. The chip scale current sensor package of claim 6 or 7,
wherein solder balls (9) are arranged in the openings (80) of the cover layer (8).

9. A method of producing a current sensor package, comprising:
- providing an IC chip (1) with a sensor (5) for measuring a magnetic field,
- arranging IC pads (7) for external electrical connection at a main surface (10) of the IC chip (1), and
- arranging an electrical conductor (2) provided with contacts (9) for applying an electric current above the main surface (10),
**characterized in that**
- the electrical conductor (2) is applied to the main surface (10) as an electrically conductive layer such that
- the sensor (5) is arranged for a measurement of a magnetic field generated by an electric current flowing in the electrically conductive layer (2), and
- the electrically conductive layer (2) is insulated from the IC pads (7).

10. The method according to claim 9, wherein the electrically conductive layer (2) is arranged between polyimide layers (3, 8).

11. The method according to claim 9 or 10, wherein the electrically conductive layer (2) is a metal layer that is applied by electrochemical deposition.

12. The method according to one of claims 9 to 11, further comprising:
arranging contact pads (4) on the IC pads (7), the contact pads (4) being applied together with the electrically conductive layer (2) and from the same material as the electrically conductive layer (2).

13. The method according to one of claims 9 to 12, further comprising:
forming a plurality of solder balls (9) on the electrically conductive layer (2).
